# EUROPÄISCHE PATENTSCHRIFT

(11) **EP 3 837 485 B1**
(45) Veröffentlichungstag und Bekanntmachung des Hinweises auf die Patenterteilung: **13.11.2024**
(21) Anmeldenummer: 19718629.9
(22) Anmeldetag: 11.04.2019
(51) Int. Cl.: F28F 13/00, H05K 7/20, H01L 23/367

(54) **VORRICHTUNG**
DEVICE
DISPOSITIF

(30) Priorität: 17.08.2018 DE 102018120118
(43) Veröffentlichungstag der Anmeldung: 23.06.2021
(73) Patentinhaber: Carl Freudenberg KG, 69469 Weinheim (DE)
(72) Erfinder: KRITZER, Peter, 67147 Forst (DE); KLEMT, Michael, 74629 Pfedelbach (DE); HARWAR-LAVIGNASSE, Mario, 74613 Öhringen (DE); SCHMITT-FERRARESE, Sebastian, 69493 Hirschberg (DE); STRIEFLER, Armin, 74613 Öhringen (DE); HOFMANN, Jens, 64285 Darmstadt (DE)
(86) Internationale Anmeldenummer: PCT/EP2019/059220
(87) Internationale Veröffentlichungsnummer: WO 2020/035172

(56) Entgegenhaltungen:
- EP-A1- 1 791 177
- DE-A1- 102013 001 645
- JP-A- H0 992 760
- JP-A- S 607 155
- US-A- 4 029 999
- US-A- 5 920 458
- US-A1- 2007 177 356

## Beschreibung

Die Erfindung betrifft eine Vorrichtung, umfassend eine erste Einrichtung und eine zweite Einrichtung, wobei die erste Einrichtung eine Wärmequelle ist und wobei die zweite Einrichtung eine Kühleinrichtung ist, wobei die zweite Einrichtung von der ersten Einrichtung emittierte Wärme aufnimmt, wobei zwischen der ersten Einrichtung und der zweiten Einrichtung ein Wärmetransferelement angeordnet ist.

Aus dem Bereich der Mikroelektronik ist es bekannt, wärmeemittierende Einrichtungen wie beispielsweise Halbleiterchips mit einer Kühleinrichtung, beispielsweise mit einem Kühlkörper mit Kühlrippen zu versehen. Im Hinblick auf einen Wärmeübergang zwischen der ersten Einrichtung und der zweiten Einrichtung besteht dabei ein Problem darin, dass der Wärmeübergang zwischen den beiden Einrichtungen signifikant sinkt, sobald kein vollflächiger Kontakt zwischen den beiden Einrichtungen gegeben ist, beispielsweise indem Gas zwischen den beiden Einrichtungen eingeschlossen ist. Um einen möglichst flächigen Kontakt der Einrichtungen herzustellen, ist es aus dem Stand der Technik bekannt, flächige elastische Elemente in Form von Pads zwischen den Einrichtungen zu platzieren. Diese werden aus einer Flächenware ausgestanzt, zwischen den Einrichtungen platziert und gegebenenfalls mittels eines Klebers fixiert. Bei den Pads ist nachteilig, dass durch den Stanzvorgang eine erhebliche Abfallmenge entsteht. Dies ist insbesondere dann der Fall, wenn deren Fläche komplex ist und nicht ohne Verschnitt aus Rechtecken darstellbar ist. Darüber hinaus entstehen mehrere, den Wärmestrom behindernde Grenzflächen, wenn das Pad auf einer der Einrichtungen mittels eines Klebers fixiert wird.

Des Weiteren ist es aus dem Stand der Technik bekannt, eine wärmeleitende Paste auf einer der Einrichtungen anzubringen und die andere Einrichtung in die Paste einzudrücken. Nach dem Fügevorgang härtet die Paste aus. Bei dieser Lösung ist problematisch, dass sich während des Fügevorgangs Gaseinschlüsse oder Risse ergeben können, welche wiederum den Wärmetransport zwischen Einrichtung und Wärmeleitpaste, beziehungsweise zwischen den beiden Einrichtungen behindern. Dabei ist es möglich, dass diese Gaseinschlüsse beim Zusammenbau der Aggregate nicht entdeckt werden, was zu späteren, unerwarteten Ausfällen der Systeme führen kann. Zudem ist bereits der Aushärtungsprozess an sich problematisch. So kann die Aushärtung bei erhöhten Temperaturen erfolgen, wodurch die Verarbeitungszeit gering gehalten werden kann. Derart erhöhte Prozesstemperaturen können bei manchen Elektronikkomponenten, beispielsweise bei Lithium-Ionen-Zellen, schädlich sein. Alternativ kann die Aushärtung bei Raumtemperatur stattfinden, hierbei sind allerdings lange Wartezeiten von bis zu mehreren Stunden nötig.

Die US 2007/0177356 A1 zeigt eine Vorrichtung, die eine Wärmequelle und eine Kühleinrichtung umfasst. Zwischen Wärmequelle und Kühleinrichtung ist ein Wärmetransferelement angeordnet, das mit der Kühleinrichtung verbunden ist.

Die US 4,029,999 zeigt eine Vorrichtung, die eine Wärmequelle und eine Kühleinrichtung umfasst. Die der Wärmequelle zugewandten Seite des Wärmetransferelements weist Aussparungen auf, um die wärmeerzeugenden Bauteile der Wärmequelle räumlich zu umgeben.

Bei der aus der DE 10 2013 001 645 A1 bekannten Vorrichtung ist das Wärmetransferelement unter Druck zwischen Wärmequelle und Kühleinrichtung verklemmt.

Bei der aus der JP H09 92760 A bekannten Vorrichtung ist zwischen der Wärmequelle und der Kühleinrichtung ein mit der Kühleinrichtung lösbar verbundenes Wärmetransferelement angeordnet.

Der Erfindung liegt die Aufgabe zugrunde, eine Vorrichtung mit einer wärmeemittierenden Einrichtung und einer kühlenden Einrichtung so weiterzuentwickeln, dass eine gute Wärmeleitfähigkeit zwischen den Einrichtungen gegeben ist, bei gleichzeitig einfacher und kostengünstiger Herstellbarkeit.

Diese Aufgabe wird mit den Merkmalen von Anspruch 1 gelöst. Auf vorteilhafte Ausgestaltungen nehmen die Unteransprüche Bezug.

Die Vorrichtung zur Lösung der Aufgabe umfasst eine erste Einrichtung und eine zweite Einrichtung, wobei die erste Einrichtung eine Wärmequelle ist und wobei die zweite Einrichtung eine Kühleinrichtung ist, wobei die zweite Einrichtung von der ersten Einrichtung emittierte Wärme aufnimmt, wobei zwischen der ersten Einrichtung und der zweiten Einrichtung ein Wärmetransferelement angeordnet ist, wobei das Wärmetransferelement an die erste Einrichtung oder die zweite Einrichtung angeformt ist.

Das erfindungsgemäße Wärmetransferelement ist demnach ein Formkörper, wobei die Formgebung des Formkörpers gleichzeitig mit dem Befestigen des Wärmetransferelementes an der ersten Einrichtung oder der zweiten Einrichtung erfolgt. Dabei entsteht ein Wärmetransferelement mit einer an die Einrichtung angepassten Gestalt. Dabei kann das Wärmetransferelement entweder an die wärmeemittierende erste Einrichtung oder an die kühlende zweite Einrichtung angeformt sein.

Die erste Einrichtung, welche die wärmeemittierende Einrichtung bildet, kann beispielsweise eine Komponente eines elektronischen Bauteils, einer Leistungselektronik, ein Sensor, eine elektrische Verbindung, ein Akkumulator oder dergleichen sein. Die zweite Einrichtung, die eine Kühleinrichtung ist, kann beispielsweise ein dickwandiger Kühlkörper, ein Kühlkörper mit Kühlrippen, ein flüssigkeitsdurchströmter, beziehungsweise mediendurchströmter Kühlkanal, ein Peltier-Element oder dergleichen sein.

Alternativ ist es denkbar, dass die erste Einrichtung durch die zweite Einrichtung temperiert wird. Wenn die Vorrichtung der Umgebung ausgesetzt ist, kann es bei sehr niedrigen Umgebungstemperaturen erforderlich sein, die erste Einrichtung zu erwärmen. Dies kann durch die zweite Einrichtung erfolgen. Insofern kann die zweite Einrichtung generell eine Einrichtung zum Temperieren der ersten Einrichtung sein. Bei niedrigen Umgebungstemperaturen erfolgt eine Erwärmung der ersten Einrichtung. Bei höheren Temperaturen oder bei Erreichen einer Betriebstemperatur erfolgt ein Kühlen der ersten Einrichtung.

Das Wärmetransferelement ist erfindungsgemäß elastisch. Durch die elastische Ausgestaltung des Wärmetransferelementes ist ein vollflächiger Kontakt des Wärmetransferelementes mit der Einrichtung sichergestellt, auf welchem das Wärmetransferelement platziert ist. Durch das direkte Anformen des Wärmetransferelementes an eine Einrichtung ist ein unmittelbarer flächiger Kontakt gegeben. Die elastische Struktur führt darüber hinaus dazu, dass sich das Wärmetransferelement den Oberflächenunebenheiten oder Oberflächenrauhigkeiten anpassen kann, so dass auch ein flächiger Formschluss auf mikroskopischer Ebene gewährleistet ist.

Dadurch, dass das Wärmetransferelement direkt an eine Einrichtung angeformt ist, ist das Wärmetransferelement auch fest mit dieser Einrichtung verbunden. Dadurch ist eine Verliersicherheit gegeben und es wird die Anzahl der Montageschritte reduziert.

Das Wärmetransferelement, welches auf der einen Einrichtung angebracht ist, kann eine auf die andere Einrichtung angepasste Gestalt aufweisen. Das Wärmetransferelement bildet insofern eine Aufnahme für die andere Einrichtung, was einerseits einen besonders guten Wärmetransport bedeutet und andererseits auch die Fertigung vereinfacht.

Das Wärmetransferelement kann Ausnehmungen zur Aufnahme der Einrichtung aufweisen, an welche das Wärmetransferelement nicht unmittelbar angeformt ist. Bei dieser Ausgestaltung steht die andere Einrichtung nicht nur flächig, beziehungsweise einseitig mit dem Wärmetransferelement in Kontakt, es ist vielmehr eine große Kontaktfläche zwischen der anderen Einrichtung und dem Wärmetransferelement gegeben, was den Wärmetransport nochmals verbessert. Zudem ist die Einrichtung durch die Einbettung in der Ausnehmung vor externen Einflüssen, beispielsweise vor Vibrationen, mechanischen Schlägen, Verschmutzung und - bei vollständiger Umschließung - auch gegen das Eindringen von Fluiden geschützt.

Das Wärmetransferelement ist erfindungsgemäß aus spritzgießfähigem Werkstoff ausgebildet. Im Spritzgießvorgang liegt der Werkstoff des Wärmetransferelementes in flüssiger Form vor und wird mit hohem Druck auf die Einrichtung aufgebracht. Dabei werden auch feine Konturen der Einrichtung verfüllt, so dass über die gesamte Oberfläche ein flächiger Kontakt, auch auf mikroskopischer Ebene, gegeben ist. Des Weiteren kann ausgeschlossen werden, dass thermisch isolierende und einen elektrischen Kriechweg bildende Gasblasen zwischen Einrichtung und Wärmetransferelement auftreten. In diesem Zusammenhang kommen für das Wärmetransferelement elastomere Werkstoffe oder thermoplastische Elastomere infrage. Diese Werkstoffe weisen ein elastisches Verhalten auf und ermöglichen einen vollflächigen Kontakt der beiden Einrichtungen.

Das Material des Wärmetransferelementes kann thermisch leitfähige Partikel aufweisen. Derartige Partikel sind beispielsweise Graphitpartikel. Die Wärmeleitfähigkeit des Materials des Wärmetransferelementes beträgt vorzugsweise mindestens 0,5 W/(m·K).

Alternativ zu den Graphitpartikeln kann das Material des Wärmetransferelementes andere thermisch leitfähige und elektrisch isolierende Partikel aufweisen. Derartige Partikel sind beispielsweise mineralische Oxide, beispielsweise Aluminiumoxid (Al₂O₃), Hydroxide wie Aluminiumhydroxid (Al(OH)₃) oder Nitride, beispielsweise Bornitrid (BN).

Die Einrichtung, an die das Wärmetransferelement angeformt ist, kann aus metallischem Werkstoff bestehen. In diesem Zusammenhang kommen insbesondere Einrichtungen aus Aluminium oder Kupfer in Betracht. Diese Werkstoffe weisen eine besonders hohe Wärmeleitfähigkeit auf. Durch das Wärmetransferelement, welches direkt an die Einrichtung angeformt ist, ist ein besonders hoher Wärmeübergang gegeben.

In einer alternativen Ausgestaltung kann die Einrichtung, an die das Wärmetransferelement angeordnet ist, aus Kunststoff ausgebildet sein. Dabei ist der Kunststoff vorzugsweise ein spritzgießfähiger Kunststoff. Durch die Verwendung eines Kunststoffs ergeben sich Gewichtsvorteile und eine vereinfachte Herstellbarkeit. Ebenso wie das Material des Wärmetransferelementes kann das Material der Einrichtung mit wärmeleitenden Partikeln versehen sein, beispielsweise mit Graphitpartikeln. Die Wärmeleitfähigkeit der aus Kunststoff ausgebildeten Einrichtung beträgt vorzugsweise mindestens 0,5 W/(m·K). Bei dieser Ausgestaltung ist die Einrichtung vorzugsweise die kühlende Einrichtung und das Wärmetransferelement ist direkt an die kühlende Einrichtung angeformt.

Eine besonders kostengünstige Herstellbarkeit und ein besonders guter Verbund aus Einrichtung und Wärmetransferelement ergeben sich, wenn die Einrichtung mit angeformtem Wärmetransferelement aus Zweikomponenten-Spritzguss ausgebildet ist.

Einige Ausgestaltungen der erfindungsgemäßen Vorrichtung werden nachfolgend anhand der Figuren näher erläutert. Diese zeigen, jeweils schematisch:
- Fig. 1: eine Vorrichtung mit an der zweiten Einrichtung angeformtem Wärmetransferelement;
- Fig. 2: eine Vorrichtung mit einer zweiten Einrichtung in Form eines Kühlkanals;
- Fig. 3: eine Vorrichtung mit an die erste Einrichtung angepasstem Wärmetransferelement;
- Fig. 4: eine Vorrichtung mit Aufnahmen für die Einrichtungen;
- Fig. 5: verschiedene Ausgestaltungen von Wärmetransferelementen;
- Fig. 6: eine Vorrichtung mit Kühlrippen;
- Fig. 7: ein Wärmetransferelement mit Dichtfunktion;
- Fig. 8: eine zweite Einrichtung mit Kühlkanälen;
- Fig. 9: eine Vorrichtung mit Leitelement zwischen Wärmetransferelement und zweiter Einrichtung;
- Fig. 10: eine Vorrichtung mit Leitelementen, welche in die zweite Einrichtung eingebettet sind;
- Fig. 11: eine zweite Einrichtung mit funktionalisierter Oberfläche;
- Fig. 12: eine zweite Einrichtung mit elektrisch leitfähiger Lage;
- Fig. 13: verschiedene Ausgestaltungen des Anformbereiches zwischen Wärmetransferelement und Einrichtung.

Die Figuren zeigen eine Vorrichtung 1 mit einer ersten Einrichtung 2 und einer zweiten Einrichtung 3. Die erste Einrichtung 2 ist eine Wärmequelle, insbesondere ein elektronisches Bauteil, welches Wärme emittiert. Insofern kann die erste Einrichtung 2 ein Akkumulator, eine Komponente aus der Mikroelektronik, eine Komponente der Leistungselektronik, beispielsweise eine Stromschiene, ein Kondensator, ein Leistungsmodul, ein Transistor, ein MOSFET, ein Bipolartransistor (IGBT) oder dergleichen sein. Die zweite Einrichtung 3 ist eine Kühleinrichtung und kann beispielsweise als metallischer Kühlkörper mit Kühlrippen, als flüssigkeitsdurchströmter Kühlkanal, als Peltier-Element oder dergleichen ausgebildet sein. Ist die Einrichtung 3 ein durchströmter Kanal, kann das Kühlmedium, beispielsweise Wasser, Wasserglykol, ein Öl oder auch ein aus der Klimatechnik bekanntes Medium wie beispielsweise CO₂, R1234yf oder Ammoniak sein.

Zwischen der ersten Einrichtung 2 und der zweiten Einrichtung 3 ist ein Wärmetransferelement 4 angeordnet. Dabei ist das Wärmetransferelement 4 entweder an die erste Einrichtung 2 oder an die zweite Einrichtung 3 angeformt.

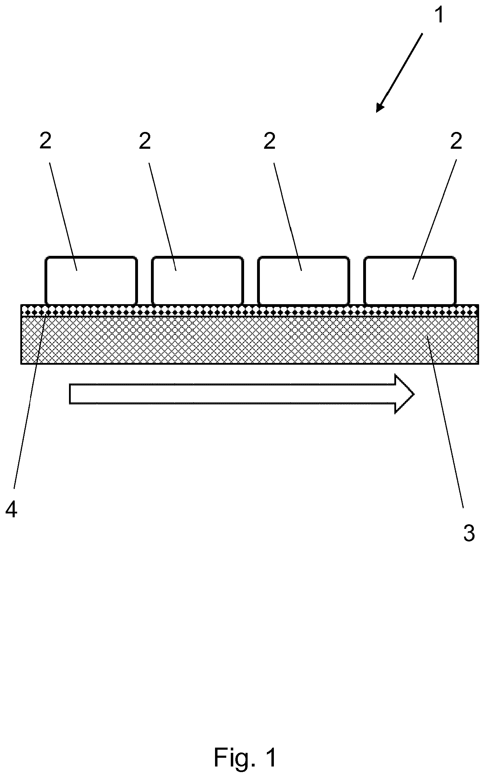

Figur 1 zeigt eine erste Ausgestaltung der Vorrichtung 1. Bei der vorliegenden Ausgestaltung ist das Wärmetransferelement 4 direkt an die zweite Einrichtung 3 angeformt, welche die Kühleinrichtung bildet. Dabei ist die zweite Einrichtung 3 ein passives Kühlelement, welches aus metallischem Werkstoff besteht und mit Kühlrippen versehen ist. Die Kühlrippen sind auf der der ersten Einrichtung 2 abgewandten Seite aus der zweiten Einrichtung 3 ausgeformt. Das Wärmetransferelement 4 liegt flächig auf der zweiten Einrichtung 3 auf. Das Wärmetransferelement 4 ist elastisch ausgebildet, besteht aus elastomerem Werkstoff und ist mittels Spritzgießen direkt auf die zweite Einrichtung 3 angeformt. Dadurch ist das Wärmetransferelement 4 stoffschlüssig mit der zweiten Einrichtung 3 verbunden.

Auf der der zweiten Einrichtung 3 abgewandten Seite des Wärmetransferelementes 4 sind mehrere erste Einrichtungen 2 angeordnet. Die ersten Einrichtungen 2 sind elektrotechnische Komponenten, welche im Betrieb Wärme abgeben. Die ersten Einrichtungen 2 liegen flächig auf dem Wärmetransferelement 4 auf und übertragen die Wärme über das Wärmetransferelement 4 in die zweite Einrichtung 3. Die zweite Einrichtung 3 gibt die aufgenommene Wärme an die Umgebung ab.

Bei der vorliegenden Ausgestaltung besteht das Wärmetransferelement 4 aus einem thermisch leitfähigen Silikon-Elastomer und weist eine Wärmeleitfähigkeit von 1,5 W/(m·K) auf. Zur Erhöhung der Wärmeleitfähigkeit ist das thermisch leitfähige Silikon-Elastomer mit thermisch leitfähigen Füllstoffen, vorliegend in Form von Aluminiumoxid (Al₂O₃), versehen.

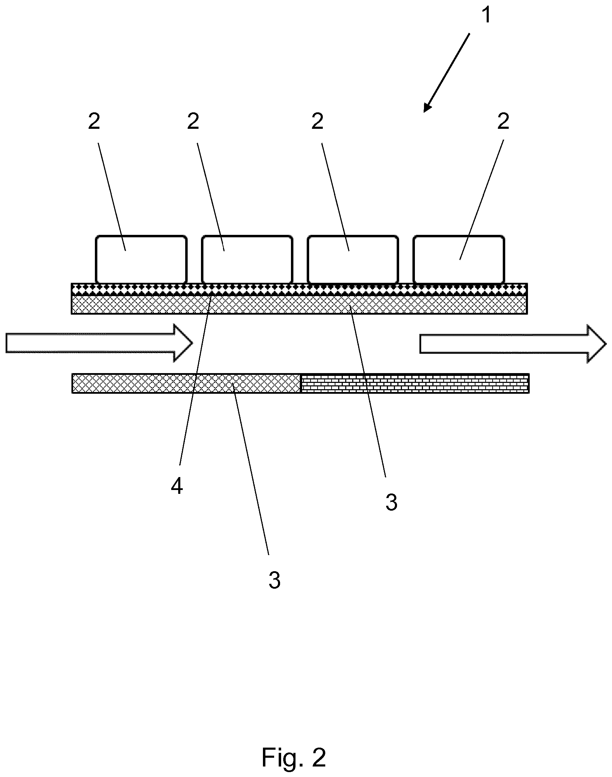

Figur 2 zeigt eine Weiterbildung der in Figur 1 gezeigten Vorrichtung 1. Bei der vorliegenden Ausgestaltung ist die zweite Einrichtung 3 als Kühlkanal ausgebildet. Dabei ist die zweite Einrichtung im Querschnitt betrachtet als Rechteckkanal ausgebildet und weist auf einer Seite ein direkt angeformtes Wärmetransferelement 4 auf, auf welchem wiederum die ersten Einrichtungen 2 angeordnet sind. Die von den ersten Einrichtungen 2 emittierte Wärme wird über das Wärmetransferelement 4 in die zweite Einrichtung 3 eingebracht und dort wiederum an das dort transportierte Kühlmedium abgegeben. Kühlmedien können beispielsweise flüssige Medien wie Wasser oder ein Wasser/Glykol-Gemisch sein. Des Weiteren können die Kühlmedien so gewählt sein, dass diese beim Kühlvorgang einem Phasenübergang unterliegen. Dies sind beispielsweise aus der Klimatechnik bekannte Kühlmedien wie R1234yf, Ammoniak, CO₂ oder Alkane. Denkbar sind auch Medien die in der Vorrichtung drucklos verdampfen und Medien die in überkritischem Zustand durch die Anordnung geführt werden.

Die dem Wärmetransferelement 4 gegenüberliegende Wand der zweiten Einrichtung 3 kann aus demselben Werkstoff bestehen wie die dem Wärmetransferelement 4 zugewandte Wand oder aus einem anderen Material bestehen.

Bei der vorliegenden Ausgestaltung besteht die zweite Einrichtung 3 aus einem spritzgießfähigem Kunststoff. Zur Erhöhung der Wärmeleitfähigkeit ist der thermoplastische Werkstoff der zweiten Einrichtung 3 mit thermisch leitfähigen Partikeln in Form von Graphit-Partikeln versehen.

Die zweite Einrichtung 3 und das Wärmetransferelement 4 wurden gemeinsam im Zweikomponenten-Spritzguss gefertigt.

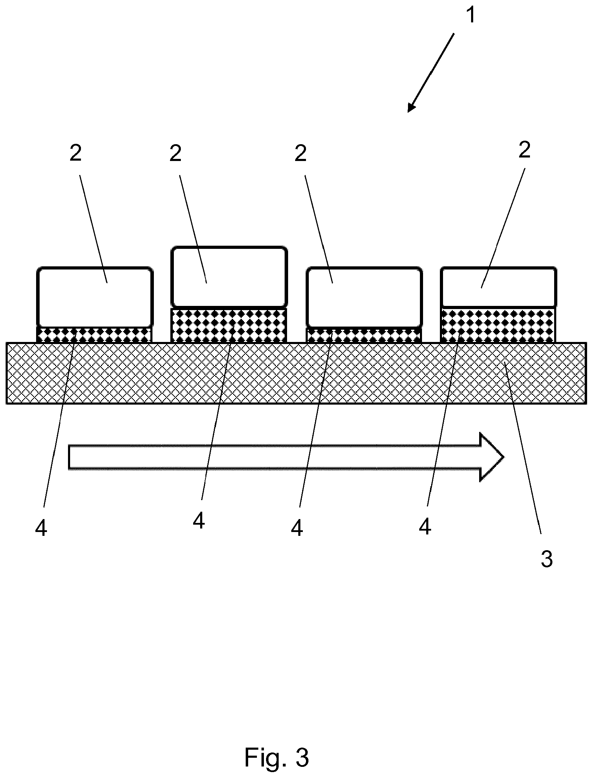

Figur 3 zeigt eine Weiterentwicklung der in Figur 1 gezeigten Vorrichtung 1. Bei der vorliegenden Ausgestaltung weisen die ersten Einrichtungen 2 konstruktionsbedingt unterschiedliche Höhenlagen relativ zu der zweiten Einrichtung 3 auf. Darüber hinaus weisen nicht alle ersten Einrichtungen 2 übereinstimmenden Dimensionen auf. Um einen vollflächigen Kontakt und eine gute Wärmeübertragung zwischen den ersten Einrichtungen 2 und der zweiten Einrichtung 3 zu gewährleisten, weist das Wärmetransferelement 4 daher eine auf die ersten Einrichtungen 2 angepasste Gestalt auf. Dabei ist das Wärmetransferelement 4 direkt an die zweite Einrichtung 3 angeformt, wobei die Formgebung so erfolgt, dass die Anordnung der ersten Einrichtungen 3 und deren Dimensionen berücksichtigt sind. Nach der Montage der ersten Einrichtungen 2 beziehungsweise der zweiten Einrichtung 3 mit dem Wärmetransferelement 4 ist ein vollflächiger Kontakt zwischen den ersten Einrichtungen 2, dem Wärmetransferelement 4 und der zweiten Einrichtung 3 gegeben.

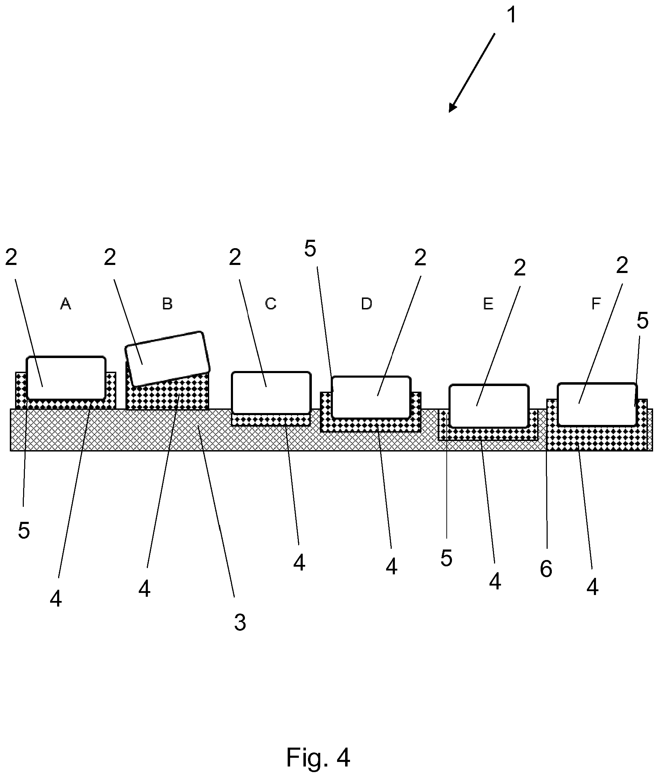

Figur 4 zeigt eine Weiterbildung der in Figur 3 gezeigten Vorrichtung 1.

Das Wärmetransferelement 4, welches der in Abschnitt A angeordneten ersten Einrichtung 2 zugeordnet ist, weist eine Ausnehmung 5 zur Aufnahme der ersten Einrichtung 2 auf. Dadurch verbessert sich die Wärmeabfuhr, da das Wärmetransferelement 4 auch an den Seitenflächen der ersten Einrichtung 2 anliegt. Darüber hinaus bildet das Wärmetransferelement 4 eine Schutzvorrichtung, in welchen die erste Einrichtung 2 zumindest teilweise eingebettet ist.

Die erste Einrichtung 2, die im Abschnitt B angeordnet ist, weist relativ zu der zweiten Einrichtung 3 eine Schrägstellung auf. Um die Schrägstellung zu kompensieren, weist das Wärmetransferelement 4 eine auf die erste Einrichtung 2 angepasste Gestalt auf.

Die in Abschnitt C angeordnete erste Einrichtung 2 ist teilweise in die zweite Einrichtung 3 eingelassen. Hierzu ist eine Ausnehmung in die zweite Einrichtung 3 eingebracht, welche das Wärmetransferelement 4 und teilweise die erste Einrichtung 2 aufnimmt.

Die in Abschnitt D angeordnete erste Einrichtung ist zumindest teilweise in das Wärmetransferelement 4 eingebettet. Dazu weist das Wärmetransferelement 4 eine Ausnehmung 5 auf. Das Wärmetransferelement 4 wiederum ist in eine in die zweite Einrichtung 3 eingebrachte Ausnehmung angeordnet.

Bei der in Abschnitt E gezeigten ersten Einrichtung 2 ist die Lage der ersten Einrichtung 2 derart, dass das Wärmetransferelement 4 vollkommen in einer Ausnehmung der zweiten Einrichtung 3 angeordnet ist. Das Wärmetransferelement 4 weist wiederum eine Ausnehmung 5 zur Aufnahme der ersten Einrichtung 2 auf.

Bei der in Abschnitt F gezeigten ersten Einrichtung 2 ist eine Durchbrechung 6 in die zweite Einrichtung 3 eingebracht, so dass das Wärmetransferelement 4 unmittelbar in Kontakt mit einem Kühlmedium gelangen kann. In das Wärmetransferelement 4 ist eine Ausnehmung 5 eingebracht, welche die erste Einrichtung 2 zumindest teilweise aufnimmt.

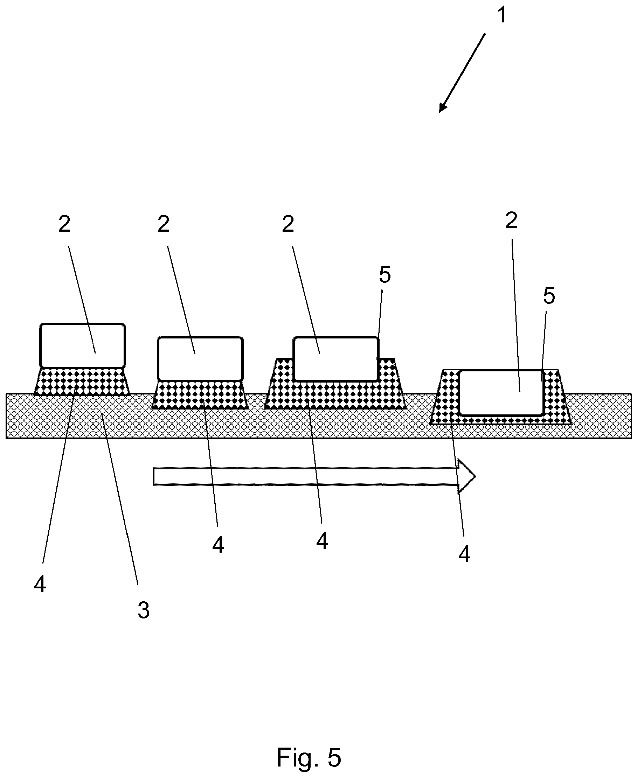

Figur 5 zeigt verschiedene Ausgestaltungen von Wärmetransferelementen 4. Bei der vorliegenden Ausgestaltung sind die Wärmetransferelemente 4 pyramidenstumpfförmig ausgebildet. Diese Gestalt ist vorteilhaft in Bezug auf eine mechanische Beanspruchung in Querrichtung.

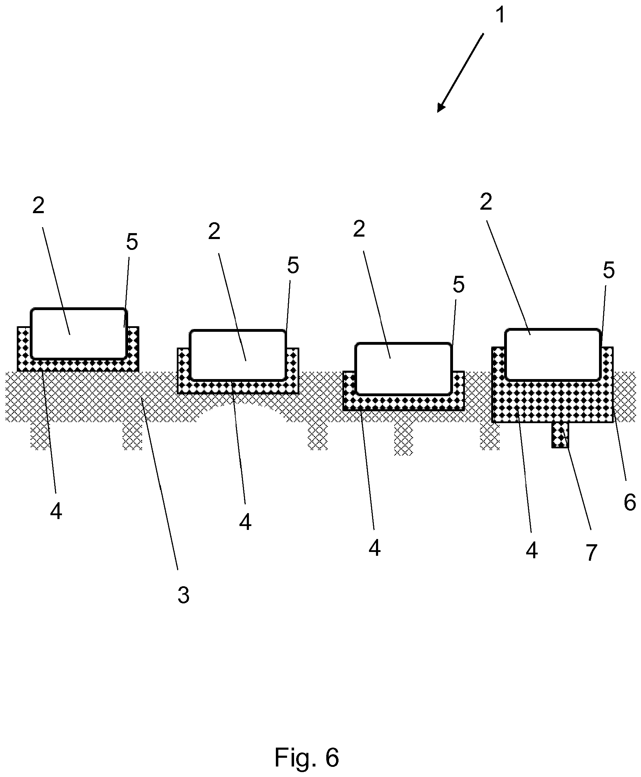

Figur 6 zeigt eine Weiterbildung der in Figur 4 gezeigten Vorrichtung 1. Bei der vorliegenden Ausgestaltung ist die zweite Einrichtung 3 mit Kühlrippen versehen, wobei auch direkt aus dem Wärmetransferelement 4 Kühlrippen 7 ausgebildet sein können, welche in Kontakt mit einem Kühlmedium stehen.

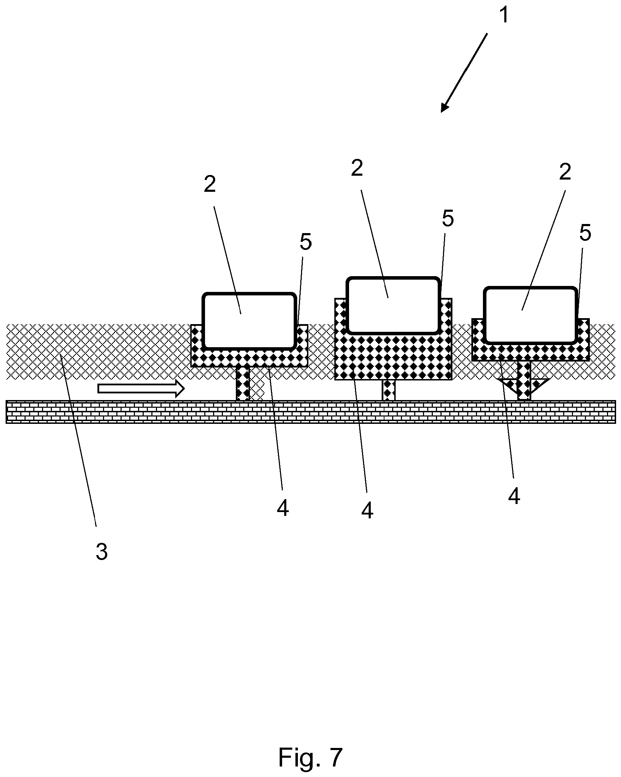

Figur 7 zeigt eine Weiterbildung der in Figur 6 gezeigten Vorrichtung 1. Dabei ist das Wärmetransferelement 4 als Dichtelement ausgestaltet. Das Wärmetransferelement 4 dichtet in diesem Fall den als Kühlkanal ausgebildete zweite Einrichtung 3 gegen die Gegenfläche ab. Dabei kann das Wärmetransferelement 4 im Kraftnebenschluss oder im Krafthauptschluss angeordnet sein. Eine zusätzliche mechanische Verankerung durch das Einbringen von Hinterschnitten des Wärmetransferelementes 4 an der Unterseite der zweiten Einrichtung 3 bietet Vorteile bei Beanspruchung in Zugrichtung

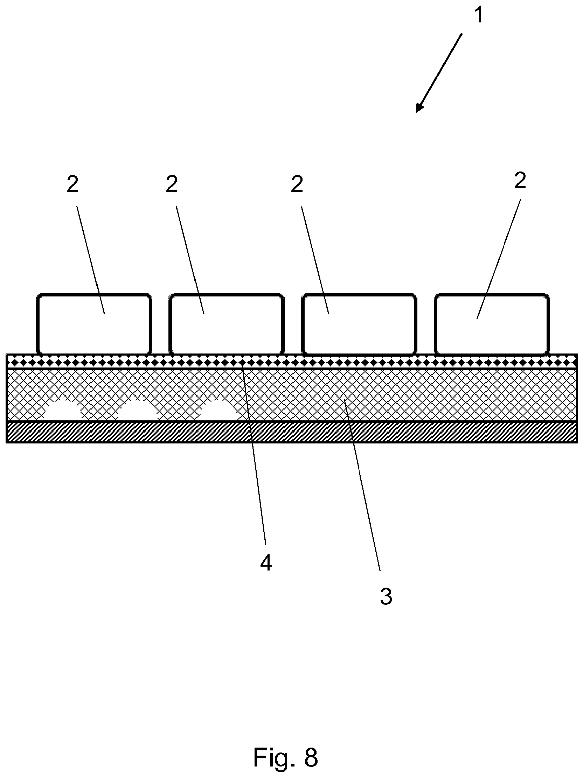

Figur 8 zeigt eine Weiterbildung der in Figur 1 gezeigten Vorrichtung 1. Bei der vorliegenden Ausgestaltung ist die zweite Einrichtung 3 mit Kanälen versehen, durch welche ein Kühlmedium strömen kann. Je nach Ausgestaltung der Kanäle ergibt sich im Inneren eine turbulente Strömung und eine hohe Kühlleistung. Die Abdichtung der Kanäle kann beispielsweise durch eine aufgebrachte Abdeckfolie erzielt werden.

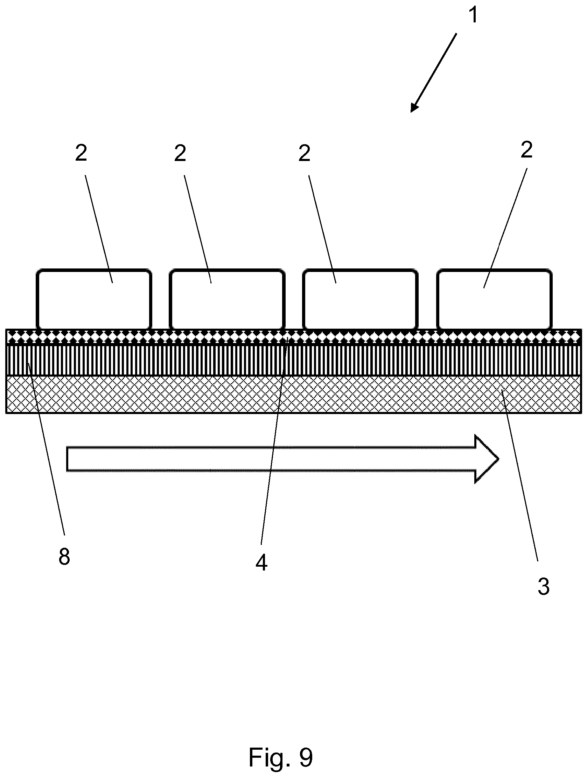

Figur 9 zeigt eine Weiterbildung der in Figur 1 gezeigten Vorrichtung 1. Dabei ist zwischen dem Wärmetransferelement 4 und der zweiten Einrichtung 3 ein Leitelement 8 angeordnet. Das Leitelement 8 verteilt die von den ersten Einrichtungen 2 abgegebene Wärme flächig über die gesamte Oberfläche der zweiten Einrichtung 3. Das Leitelement 8 kann aus metallischem Material oder aus Graphit bestehen und in Form einer Platte oder einer Folie ausgebildet sein.

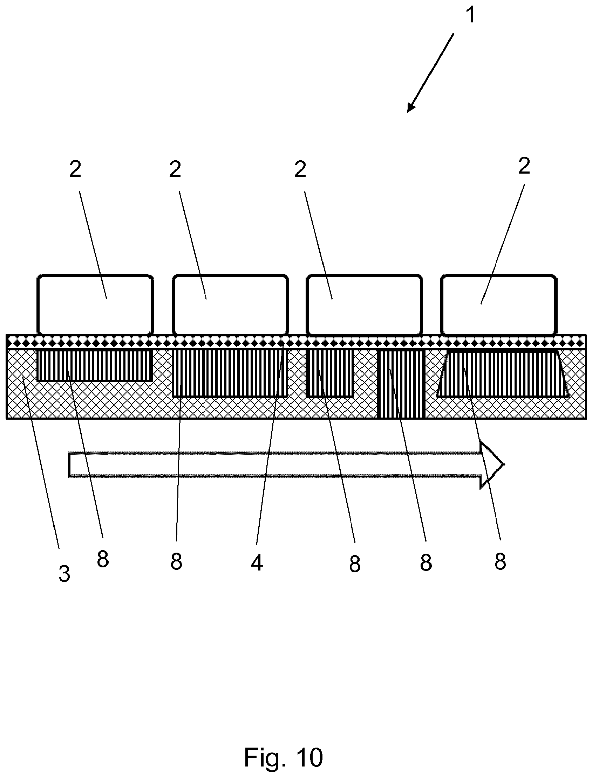

Figur 10 zeigt eine Weiterbildung der in Figur 9 gezeigten Vorrichtung 1. Bei der vorliegenden Ausgestaltung sind die Leitelemente 8 als Einlegeelemente ausgebildet und in die zweite Einrichtung 3 integriert. Hierbei sind vor allem metallische Bauteile denkbar.

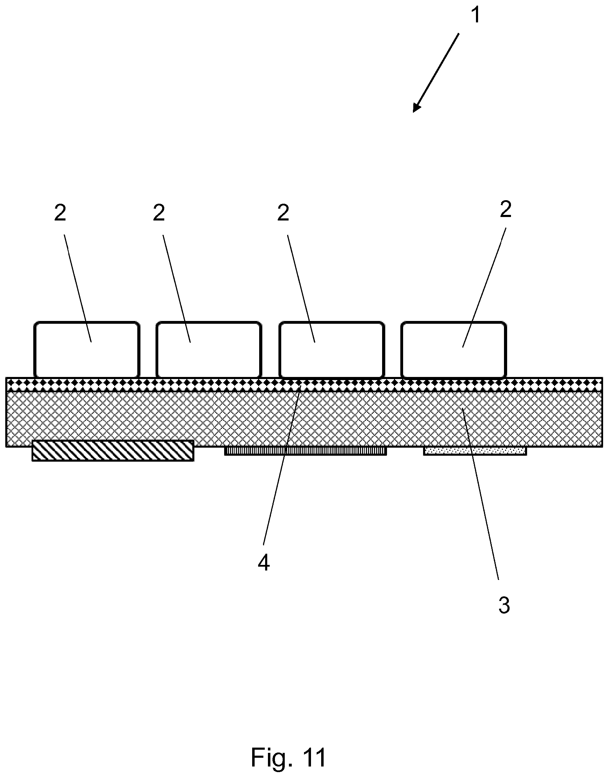

Figur 11 zeigt eine Weiterbildung der in Figur 1 gezeigten Vorrichtung 1. Dabei ist die zweite Einrichtung 3 auf der dem Kühlmedium zugewandten Seite mit einer makroskopischen Strukturierung mit Strukturtiefen zwischen 10 und 1.000 µm versehen. Diese vergrößern die Oberfläche und verbessern damit den Wärmeübergang. Alternativ kann eine mikroskopische Strukturierung mit Strukturtiefen bis 10 µm vorgesehen sein. Eine weitere Möglichkeit besteht darin, die Grenzfläche der zweiten Einrichtung 3 in Richtung des Kühlmediums mit einer Beschichtung zu versehen.

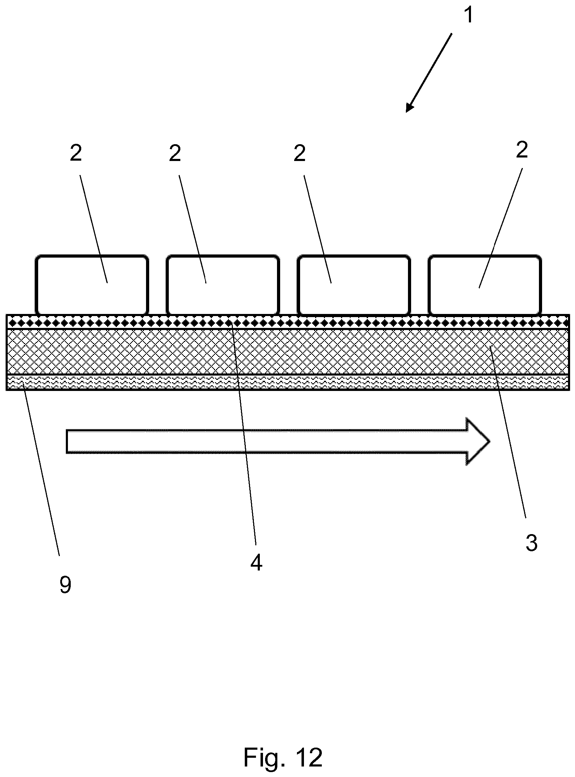

Figur 12 zeigt eine Weiterbildung der in Figur 1 gezeigten Vorrichtung 1. Bei der vorliegenden Ausgestaltung ist auf der dem Wärmetransferelement 4 abgewandten Seite der zweiten Einrichtung 3 eine zusätzliche Lage 9 aufgebracht, welche elektrisch leitfähig ist. Die zusätzliche 9 Lage kann in Form einer Beschichtung auf die zweite Einrichtung 3 aufgebracht sein. Alternativ kann die zusätzliche Lage 9 als elektrisch leitfähige Folie, elektrisch leitfähiges Gewebe, elektrisch leitfähiges Netz oder als elektrisch leitfähiger Vliesstoff ausgebildet sein und an der zweiten Einrichtung 3 befestigt sein. Durch die zusätzliche Lage 9 kann eine elektromagnetische Abschirmung der ersten Einrichtungen 2 erzielt werden. Ist die Vorrichtung 1 beispielsweise als Gleichstrom-Wechselstrom-Inverter ausgebildet, kann eine Emission elektromagnetischer Strahlung der ersten Einrichtungen 2 vermieden werden. Ist die Vorrichtung 1 gemäß einem weiteren Beispiel ein Batterie-Management-System können die ersten Einrichtungen 2 vor von außen ankommender elektromagnetischer Strahlung geschützt werden.

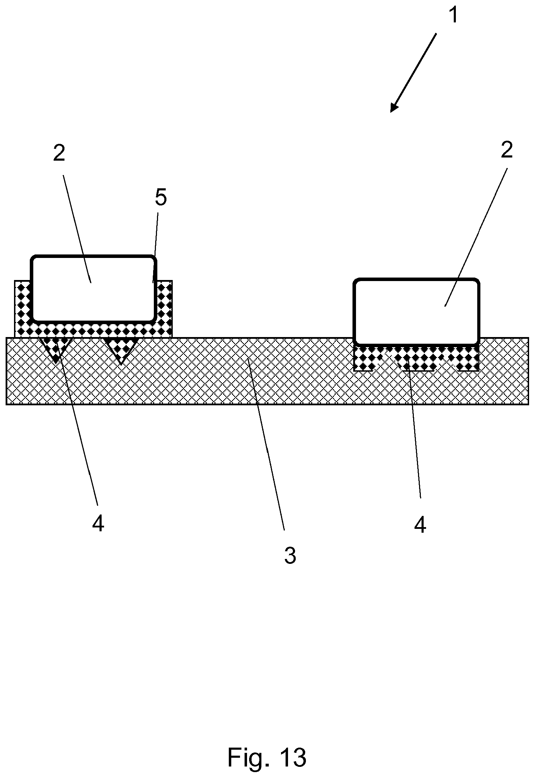

Figur 13 zeigt eine Weiterentwicklung der in Figur 3 gezeigten Vorrichtung 1, wobei die Grenzfläche zwischen Wärmetransferelement 4 und der zweiten Einrichtung 3 im Anformbereich keine planare Ausgestaltung aufweist. Dies ist insbesondere vorteilhaft bei mechanisch beanspruchten Anwendungen sowie für einen verbesserten Wärmeübergang. Eine derartige Ausgestaltung ist durch plättchenförmige Wärmetransferelemente nicht realisierbar, ohne dass es zu Gaseinschlüssen kommt.

## Patentansprüche

1. Vorrichtung (1), umfassend eine erste Einrichtung (2) und eine zweite Einrichtung (3), wobei die erste Einrichtung (2) eine Wärmequelle ist und wobei die zweite Einrichtung (3) eine Kühleinrichtung ist, wobei die zweite Einrichtung (3) von der ersten Einrichtung (2) emittierte Wärme aufnimmt, wobei zwischen der ersten Einrichtung (2) und der zweiten Einrichtung (3) ein Wärmetransferelement (4) angeordnet ist, wobei das Wärmetransferelement (4) derart an die erste Einrichtung (2) oder die zweite Einrichtung (3) angeformt ist, dass das Wärmetransferelement (4) fest mit der ersten Einrichtung (2) oder der zweiten Einrichtung (3) verbunden ist, wobei das Wärmetransferelement (4) aus elastomerem Werkstoff besteht und elastisch ist, **dadurch gekennzeichnet, dass** das Wärmetransferelement (4) aus spritzgießfähigem Werkstoff ausgebildet ist und mittels Spritzgießen direkt auf die erste Einrichtung (2) oder die zweite Einrichtung (3) angeformt ist, so dass das Wärmetransferelement (4) stoffschlüssig mit der ersten Einrichtung (2) oder der zweiten Einrichtung (3) verbunden ist.

2. Vorrichtung nach Anspruch 1, **dadurch gekennzeichnet, dass** das auf der einen Einrichtung (2, 3) angebrachte Wärmetransferelement (4) eine auf die andere Einrichtung (2, 3) angepasste Gestalt aufweist.

3. Vorrichtung nach Anspruch 2, **dadurch gekennzeichnet, dass** das Wärmetransferelement (4) Ausnehmungen (5) zur Aufnahme der anderen Einrichtung (2, 3) aufweist.

4. Vorrichtung nach einem der Ansprüche 1 bis 3, **dadurch gekennzeichnet, dass** die Einrichtung (2, 3), an welche das Wärmetransferelement (4) angeformt ist, aus metallischem Werkstoff besteht.

5. Vorrichtung nach einem der Ansprüche 1 bis 3, **dadurch gekennzeichnet, dass** die Einrichtung (2, 3), an welche das Wärmetransferelement (4) angeformt ist, aus Kunststoff ausgebildet ist.

6. Vorrichtung nach Anspruch 5, **dadurch gekennzeichnet, dass** der Kunststoff ein spritzgießfähiger Kunststoff ist.

7. Vorrichtung nach Anspruch 5 oder 6, **dadurch gekennzeichnet, dass** die Einrichtung (2, 3) zusammen mit dem angeformten Wärmetransferelement (4) aus Zweikomponenten-Spritzguss ausgebildet ist.

## Claims

1. Apparatus (1) comprising a first device (2) and a second device (3), wherein the first device (2) is a heat source and wherein the second device (3) is a cooling device, wherein the second device (3) takes up heat emitted by the first device (2), wherein a heat transfer element (4) is arranged between the first device (2) and the second device (3), wherein the heat transfer element (4) is moulded on the first device (2) or the second device (3) such that the heat transfer element (4) is fixedly connected to the first device (2) or the second device (3), wherein the heat transfer element (4) consists of elastomer material and is elastic, **characterized in that** the heat transfer element (4) is made of injection-mouldable material and is integrally moulded by injection moulding directly onto the first device (2) or the second device (3), with the result that the heat transfer element (4) is in a materially bonded connection with the first device (2) or the second device (3) .

2. Apparatus according to Claim 1, **characterized in that** the heat transfer element (4) mounted on the one device (2, 3) has a form matched to the other device (2, 3) .

3. Apparatus according to Claim 2, **characterized in that** the heat transfer element (4) has recesses (5) for receiving the other device (2, 3).

4. Apparatus according to one of Claims 1 to 3, **characterized in that** the device (2, 3) on which the heat transfer element (4) is integrally moulded consists of metallic material.

5. Apparatus according to one of Claims 1 to 3, **characterized in that** the device (2, 3) on which the heat transfer element (4) is integrally moulded is made of plastic.

6. Apparatus according to Claim 5, **characterized in that** the plastic is an injection-mouldable plastic.

7. Apparatus according to Claim 5 or 6, **characterized in that** the device (2, 3) together with the integrally moulded heat transfer element (4) is formed by two-component injection moulding.

## Revendications

1. Dispositif (1), comprenant un premier appareil (2) et un deuxième appareil (3), le premier appareil (2) étant une source de chaleur et le deuxième appareil (3) étant un appareil de refroidissement, le deuxième appareil (3) recevant la chaleur émise par le premier appareil (2), un élément de transfert de chaleur (4) étant agencé entre le premier appareil (2) et le deuxième appareil (3), l'élément de transfert de chaleur (4) étant formé sur le premier appareil (2) ou le deuxième appareil (3) de telle sorte que l'élément de transfert de chaleur (4) est relié de manière fixe au premier appareil (2) ou au deuxième appareil (3), l'élément de transfert de chaleur (4) étant constitué de matériau élastomère et étant élastique, **caractérisé en ce que** l'élément de transfert de chaleur (4) est réalisé en matériau pouvant être moulé par injection et est formé directement sur le premier appareil (2) ou le deuxième appareil (3) par moulage par injection, de telle sorte que l'élément de transfert de chaleur (4) est relié par liaison de matière au premier appareil (2) ou au deuxième appareil (3).

2. Dispositif selon la revendication 1, **caractérisé en ce que** l'élément de transfert de chaleur (4) monté sur l'un des appareils (2, 3) présente une forme adaptée à l'autre appareil (2, 3).

3. Dispositif selon la revendication 2, **caractérisé en ce que** l'élément de transfert de chaleur (4) présente des évidements (5) pour recevoir l'autre appareil (2, 3).

4. Dispositif selon l'une quelconque des revendications 1 à 3, **caractérisé en ce que** l'appareil (2, 3) sur lequel est formé l'élément de transfert de chaleur (4) est constitué de matériau métallique.

5. Dispositif selon l'une quelconque des revendications 1 à 3, **caractérisé en ce que** l'appareil (2, 3) sur lequel est formé l'élément de transfert de chaleur (4) est réalisé en matière plastique.

6. Dispositif selon la revendication 5, **caractérisé en ce que** la matière plastique est une matière plastique pouvant être moulée par injection.

7. Dispositif selon la revendication 5 ou 6, **caractérisé en ce que** l'appareil (2, 3) conjointement avec l'élément de transfert de chaleur formé (4) sont réalisés par moulage par injection à deux composants.
